# EUROPEAN PATENT APPLICATION

(11) **EP 2 493 280 A1**
(43) Date of publication of application: **29.08.2012**
(21) Application number: 11166200.3
(22) Date of filing: 16.05.2011
(51) Int. Cl.: H05K 9/00

(54) **Shield case for emi shielding**

(30) Priority: 25.02.2011 KR 20110017333
(71) Applicant: Joinset Co., Ltd, 425-866-Kyeonggi-do (KR); Kim, Sun-ki, Gunpo-si Kyonggi do 435-040 (KR)
(72) Inventor: Kim, Sun-ki, 435-040, Gunpo-si, Kyeonggi-do (KR)
(74) Representative: Kuhnen & Wacker

(57) **Abstract**

Provided is a shield case for electromagnetic interference shielding, including a main body having an opening in a lower surface thereof, wherein at least one portion of an upper surface of the main body is flat for vacuum pickup, and the main body has a box shape and is electrically conductive, a flange extending outward from an edge of the opening and integrally formed with the edge, and a support coupled to the flange to contact at least a lower surface of the flange. The support is adapted for soldering and is electrically conductive. After the main body and the support are mounted on a printed circuit board through a surface mount process, a lower surface of the support is electrically and mechanically connected through solder cream to a conductive pattern of the printed circuit board through a reflow soldering process.

## Description

### BACKGROUND ART

### Field of the Invention

The present invention relates to a shield case for electromagnetic interference (EMI) shielding and protecting electronic parts, and more particularly, to a shield case for EMI shielding, which is mounted on a conductive pattern of a printed circuit board through a surface mount process and is adapted for heat transfer, vision inspection, rework, and reflow soldering using solder cream.

### Description of the Related Art

In general, a high frequency electronic part or module is covered with a shield case for EMI shielding, and then, the shield case is electrically and mechanically connected to a conductive pattern of a printed circuit board, preferably, to a ground pattern, in order to prevent electromagnetic waves from being emitted out of the high frequency electronic part or module or to shield the high frequency electronic part or module from external electromagnetic waves.

In this case, the shield case may include an electrically conductive member such as a metal sheet or electrically insulating polymer resin plated with a metal to block electromagnetic waves, and has a box shape with at least one opening to cover electronic parts or modules mounted on the printed circuit board. Such a shield case for EMI shielding is electrically and mechanically connected to a ground pattern of a printed circuit board by using soldering such as reflow soldering, or physical coupling with a metal screw or a metal clip.

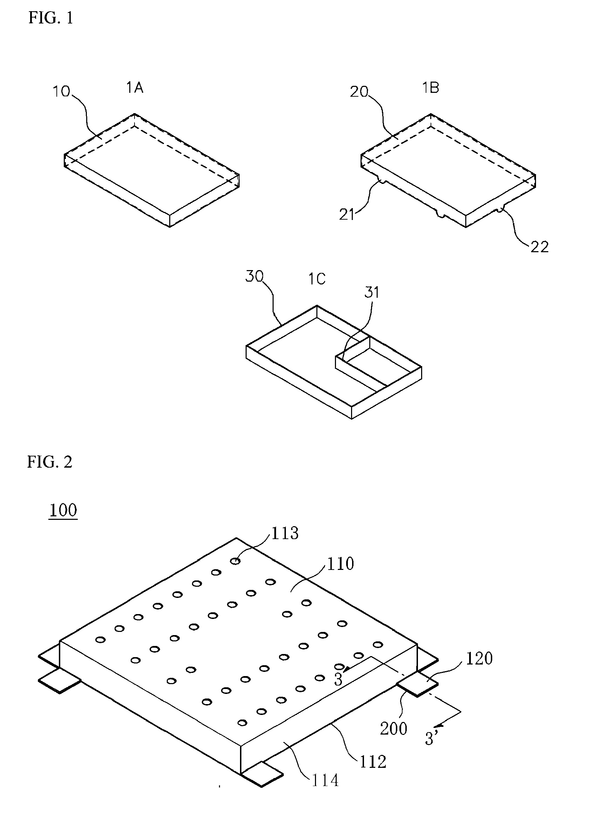

Referring to FIG. 1A, a shield case 10 for EMI shielding is formed by pressing or drawing a metal sheet. The lower end of a side wall of the shield case 10 may be soldered directly to a ground pattern of a printed circuit board, or the end of the side wall may be inserted in a metal clip installed in advance on a ground pattern. In this case, the soldering of the lower end may be reflow soldering using solder or solder cream.

Since stainless steel, which is used for a typical shield case, is resistant to soldering, when the shield case 10 is formed of stainless steel, a metal sheet constituting the shield case 10 is plated with a metal adapted for soldering, such as stannum.

Referring to FIG. 1B, a shield case 20 for EMI shielding includes tips 21 and 22 protruding from the lower end of a side wall of thereof. The tips 21 and 22 are integrally formed with the shield case 20. When the shield case 20 is soldered to a ground pattern of a printed circuit board, the tips 21 and 22 are inserted in holes formed in the ground pattern.

Referring to FIG. 1C, a shield case 30 for EMI shielding includes a EMI shielding partition 31 to separate high frequency electronic parts or modules from each other. The lower end of the EMI shielding partition 31 is soldered to a ground pattern of a printed circuit board.

However, such shield cases are not adapted for a surface mount process using vacuum pickup and a reflow soldering process using solder cream, and thus, it is difficult to improve the productivity of the shield cases and ensure the quality of the shield cases.

For example, the lower end of a shield case formed by pressing a metal sheet may have a thickness ranging from about 0.1 mm to about 0.25 mm, which is equal to the thickness of the metal sheet. When the shield case is large, the lower end of the shield case is relatively thin, compared with the size of the shield case. In this case, it may be difficult to horizontally balance the lower end of the shield case. Thus, it may be difficult to perform a reflow soldering process with a surface mount process on the entire lower end of the shield case. In particular, a thin printed circuit board may be flexible and bendable, and a shield case may have a thin side wall. In this case, external damage or bending of the thin printed circuit board limits the soldering of the lower end of the thin side wall to the thin printed circuit board. Furthermore, when a number of parts are mounted on a printed circuit board, a thin metal sheet may be required. In this case, reflow soldering is difficult, and soldering strength is degraded.

In addition, molten solder cream and an airflow generated during reflow soldering may move a shield case, which makes it difficult to ensure the reliability of reflow soldering. In addition, since a shield case should be plated with a metal adapted for soldering, such as stanuum, for soldering of the lower end of the shield case, manufacturing costs are increased. In addition, a rework process is difficult in the state where the lower end of a shield case is entirely soldered.

Although not shown, a flange may be disposed on the lower end of a shield case to facilitate reflow soldering, and be integrally formed with a side wall of the shield case. In this case, the flange and a metal sheet constituting the shield case have the same thickness, which makes it difficult to horizontally balance the flange during a manufacturing process. Since a shield case should be plated with a metal such as stanuum for soldering, costs are increased.

A shield case may be installed on a ground pattern by fitting the shield case on a metal clip soldered in advance to the ground pattern. A metal clip for fixing a shield case is disclosed in Korean Patent No. 886591.

A metal clip for fixing a shield case is lightweight and has a length greater than a width thereof, and thus, is susceptible to shaking and torsion during reflow soldering. Thus, even when just one of metal clips is not in position, inserting of a shield case having predetermined dimensions may be difficult. In addition, when a reflow flowing process is performed on a metal clip, solder may protrude over a predetermined level from the metal clip. In this case, a shield case may not be inserted down to the lower end of the metal clip. A metal clip and the bottom surface of a shield case should be reliably adhered to a conductive pattern, that is, to a ground pattern to improve EMI shielding effect. Thus, when the shield case formed of a metal is not reliably attached thereto, the EMI shielding effect may be degraded. After soldering of metal clips, a shield case is manually fitted in the metal clips, which may reduce productivity.

### Summary of the Invention

An object of the present invention is to provide a shield case for EMI shielding, which is adapted for a surface mount process using vacuum pickup and a reflow soldering process using solder cream.

Another object of the present invention is to provide a shield case for EMI shielding, which improves EMI shielding effect, soldering strength, and productivity and for protecting electronic parts installed inside the shield case from an external force.

Another object of the present invention is to provide a shield case for EMI shielding, which is adapted for a thin, flexible, and bendable printed circuit board.

Another object of the present invention is to provide a shield case for EMI shielding, which is adapted for a surface mount process and a reflow soldering process and improves soldering strength even when a thin metal sheet is required because a number of parts are mounted on a printed circuit board.

Another object of the present invention is to provide a shield case for EMI shielding, which includes an EMI shielding partition that elastically and electrically contacts a conductive pattern and economically forms an EMI shielding area.

Another object of the present invention is to provide a shield case for EMI shielding, which is resistant to shaking and misaligning during reflow soldering.

Another object of the present invention is to provide a shield case for EMI shielding, which facilitates a rework process and a vision inspection process that is performed on an electronic part installed inside the shield case before and after soldering.

Another object of the present invention is to provide a shield case for EMI shielding, which facilitates heat transfer to simultaneously perform a reflow soldering process on both an electronic part disposed inside the shield case and an electronic part disposed outside the shield case under the same reflow soldering condition.

Another object of the present invention is to provide a shield case for EMI shielding, which is efficiently removed with physical force.

Another object of the present invention is to provide a printed circuit board assembly including a shield case for EMI shielding, which is adapted for a surface mount process and a reflow soldering process using solder cream.

According to an aspect of the present invention, there is provided a shield case for electromagnetic interference shielding, including: a main body having an opening in a lower surface thereof, wherein at least one portion of an upper surface of the main body is flat for vacuum pickup, and the main body has a box shape and is electrically conductive; a flange extending outward from an edge of the opening and integrally formed with the edge; and a support coupled to the flange to contact at least a lower surface of the flange, wherein the support is adapted for soldering and is electrically conductive, wherein, after the main body and the support are mounted on a printed circuit board through a surface mount process, a lower surface of the support is electrically and mechanically connected through solder cream to a conductive pattern of the printed circuit board through a reflow soldering process.

According to another aspect of the present invention, there is provided a shield case for electromagnetic interference shielding, including: a main body having an opening in a lower surface thereof, wherein at least one portion of an upper surface of the main body is flat for vacuum pickup, and the main body has a box shape and is electrically conductive; a flange extending outward from an edge of the opening and integrally formed with the edge; a through hole disposed in the flange; and a support adapted for soldering and fitted in the through hole of the flange, the support being electrically conductive, wherein, after the main body and the support are mounted on a printed circuit board through a surface mount process, a lower surface of the support is electrically and mechanically connected through solder cream to a conductive pattern of the printed circuit board through a reflow soldering process.

The main body may include one of a member formed by pressing a metal sheet having a constant thickness, a member formed using die casting with metal powder or metal ingot, a heat resistant polymer film including a metal layer, and a metal-plated molding member of polymer resin.

The flange may be disposed on at least one portion of the edge of the opening.

A recess may be disposed in the lower surface of the flange such that an upper surface of the flange protrudes.

The support may be disposed within the recess without protruding out of the lower surface of the flange.

The lower surface of the support may be formed of a material adapted for the reflow soldering process using the solder cream.

The support may be formed by pressing a metal sheet plated with stannum.

The flange may be coupled to the support by using one of welding, soldering, clamping, riveting, and elastic deformation.

The support may include: a base contacting the solder cream and having a diameter greater than that of the through hole; a column extending from the base and integrally formed with the base and passing through the through hole; and a fixing part formed by compressing an upper end of the column or integrally formed with a part having a diameter greater than that of the through hole.

The shield case may further include a partition for electromagnetic interference shielding, wherein the partition protrudes from a lower surface of an upper part of the shield case to form an electromagnetic interference shielding area, and is formed of electrically conductive silicone rubber.

A constant gap may be formed between the lower surface of the flange and a lower end of a side wall of the main body.

The lower end of the side wall may electrically contact the conductive pattern after the reflow soldering process.

The reflow soldering process using the solder cream may be performed only on the support.

After the reflow soldering process, the main body may be coupled to or removed from the support by elastic deformation of the through hole with physical force or elastic deformation of the support with physical force.

The shield case may be adapted for the surface mount process using vacuum pickup and the reflow soldering process using the solder cream.

The main body may have an upper opening in a portion of the upper surface, and the upper opening of the main body may be covered with an electrically conductive cover that is removable.

The upper opening may be used for at least one of heat transfer, vision inspection, and rework.

Edges defining the upper opening may face each other, and be connected to each other through a bridge that is integrally formed with the edges, and a pickup land for vacuum pickup may be formed on at least one portion of the bridge.

A stopper may protrude outward from a side wall of the main body, a notch may be formed at an edge of a lower end of the cover to receive the stopper, and the stopper may be received in the notch to horizontally balance the cover.

According to another aspect of the present invention, there is provided a printed circuit board assembly including: the shield case of claim or 2; and a printed circuit board on which the shield case is mounted, wherein, after the main body and the support are mounted on the printed circuit board through a surface mounting process, the lower surface of the support is electrically and mechanically connected through solder cream to a conductive pattern of the printed circuit board through a reflow soldering process.

A via hole or a recess may be formed in the conductive pattern connected to the support through the reflow soldering process, and receive the support.

### Brief Description of the Drawings

The above objects and other advantages of the present invention will become more apparent by describing in detail preferred embodiments thereof with reference to the attached drawings in which:

FIGS. 1A, 1B and 1C are perspective views illustrating shield cases for EMI shielding in the related art;

FIG. 2 is a perspective view illustrating a shield case for EMI shielding according to an embodiment of the present invention;

FIG. 3 is a cross-sectional view taken along line 3-3' of FIG. 2;

FIG. 4 is a cross-sectional view illustrating a state in which a shield case for EMI shielding is installed on a printed circuit board according to an embodiment of the present invention;

FIGS. 5A through 5F are perspective views illustrating flanges according to embodiments of the present invention;

FIGS. 6A through 6F are perspective views illustrating supports according to embodiments of the present invention;

FIGS. 7A through 7D are views illustrating supports having various elastic deformation parts according to embodiments of the present invention;

FIGS. 8A through 8C are perspective views illustrating supports coupled to flanges according to embodiments of the present invention;

FIG. 9 is a perspective view illustrating a shield case for EMI shielding according to an embodiment of the present invention;

FIG. 10 is a perspective view illustrating a state in which the shield case of FIG. 9 is coupled to a printed circuit board;

FIG. 11 is a cross-sectional view illustrating a shield case for EMI shielding according to an embodiment of the present invention;

FIG. 12 is a cross-sectional view illustrating a shield case for EMI shielding according to another embodiment of the present invention;

FIG. 13 is a perspective view illustrating a shield case for EMI shielding according to an embodiment of the present invention; and

FIG. 14 is a view illustrating elastically deformable flanges having various structures according to embodiments of the present invention.

### Detailed Description of the preferred Embodiments

Hereinafter, embodiments of the present invention will be described in detail with reference to the accompanying drawings.

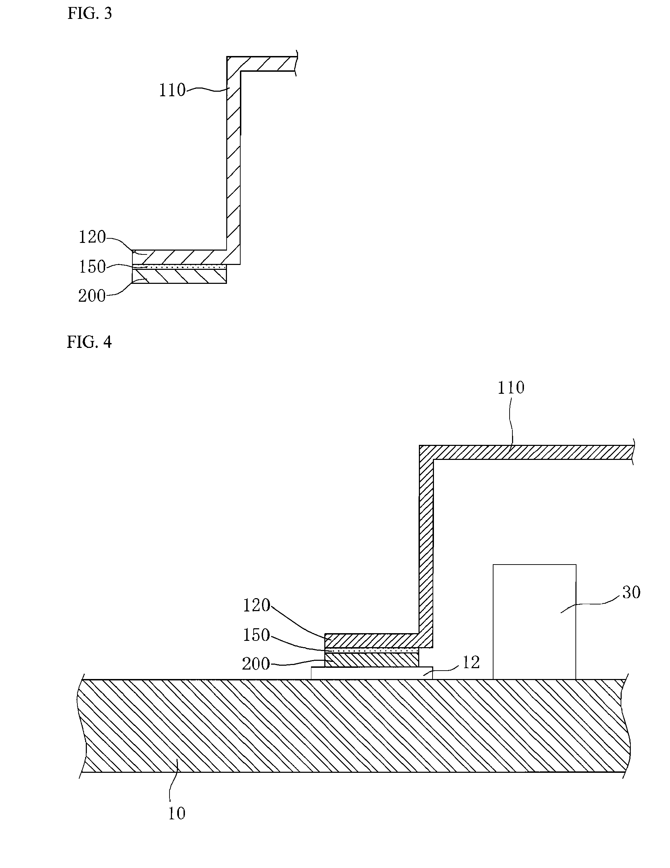

FIG. 2 is a perspective view illustrating a shield case 100 for electromagnetic interference (EMI) shielding, which facilitates both a surface mount process using vacuum pickup and a reflow soldering process using solder cream, according to an embodiment of the present invention. FIG. 3 is a cross-sectional view taken along line 3-3' of FIG. 2. FIG. 4 is a cross-sectional view illustrating a state in which the shield case 100 is installed on a printed circuit board according to the current embodiment of the present invention.

The shield case 100 includes a main body 110, flanges 120, and supports 200. The main body 110 is electrically conductive and is formed of a metal in a box shape, and has an opening 112 in a surface thereof (in a lower surface in the current embodiment). The upper surface of the main body 110 is partially flat for vacuum pickup. The flanges 120 horizontally extend outward from edges of the opening 112 and are integrally formed with the main body 110. The supports 200 are electrically conductive and are coupled to the lower surfaces of the flanges 120 through a material 150 formed by soldering or welding.

Accordingly, when the supports 200 are coupled to the lower surfaces of the flanges 120, the shield case 100 is picked up in a vacuum manner and is mounted on a conductive pattern of a printed circuit board through solder cream, and the supports 200 and the conductive pattern are soldered to each other using reflow soldering, and thus, are electrically and mechanically connected to each other, thereby mechanically protecting electronic parts and modules within the shield case 100 against the outside thereof, and electrically shielding electronic parts and modules from electromagnetic waves.

The supports 200 may be coupled to the lower surfaces of the flanges 120 by using various methods. The supports 200 may be coupled to the flanges 120 through the material 150 formed by welding or soldering. Furthermore, the supports 200 may be coupled to the flanges 120 by using clamping, riveting, or elastic deformation.

The lower surfaces of the supports 200 may be parallel to the lower surfaces of the flanges 120, but the present invention is not limited thereto.

The lower ends of side walls of the main body 110 out of the flanges 120 may be soldered using reflow soldering to the conductive pattern of the printed circuit board or may not be soldered using reflow soldering thereto. When the lower ends of the side walls are not soldered using reflow soldering thereto, the main body 110 can be easily removed from the supports 200 with physical force. Therefore, after the lower surfaces of the supports 200 are soldered using reflow soldering, a rework process is facilitated.

Referring to FIG. 4, various electronic parts 30 are mounted on a printed circuit board 10, and a conductive pattern 12 is formed thereon. The shield case 100 shields the mounted electronic parts 30 from electromagnetic waves. The flange 120 is disposed on the conductive pattern 12, and the lower surface of the support 200 coupled to the lower surface of the flange 120 is soldered to the conductive pattern 12 through solder cream (not shown). The conductive pattern may be a ground pattern.

Hereinafter, components of the shield case 100 will now be described in detail.

Main Body 110

The main body 110 may have a box shape with a tetragonal, polygonal, or circular plane. But the present invention is not limited thereto, and thus, the main body 110 may have a box shape with open upper and lower surfaces, which will be described later.

The main body 110 may be partially flat on the upper surface thereof to facilitate vacuum pickup, and may include heat emission holes 113 in the upper surface thereof to emit heat.

However, the heat emission holes 113 may function as reworking holes or holes for visually inspecting electronic parts or modules disposed within the shield case 100, before and after reflow soldering.

The main body 110 and the flanges 120 may be integrally formed of a high strength metal sheet or metal foil of stainless steel, copper, a copper alloy, or aluminum, by using a press process or a drawing process, especially, a deep drawing process. For example, the main body 110 and the flanges 120 may be formed by continuously pressing a metal sheet or foil having a constant thickness, for example, a thickness ranging from about 0.1 mm to about 0.35 mm.

Unlike this, the main body 110 and the flanges 120 may be formed by melting metal powder, and the, performing a die casting process, or be formed by injecting heat resistant insulation polymer resin, and then, plating the resin with a conductive metal.

The main body 110 and the flanges 120 may be formed of a heat resistant polymer film including a metal layer. In this case, due to the heat resistant polymer film, the shield case 100 is lightweight and flexible, and has good workability. Moreover, a side surface of the shield case 100 is insulated by the heat resistant polymer film.

Considering low costs, high mechanical strength, and rework, the main body 110 may be formed of an electrically conductive material such as stainless steel, which is resistant to a reflow soldering process with solder cream.

On the contrary, when it is necessary to perform a reflow soldering process on the lower end of the side wall of the main body 110 with solder cream, the main body 110 and the flanges 120 may be plated with stannum (Sn) that is adapted for a reflow soldering process with solder cream. In this case, EMI shielding effect can be improved, but a rework after the reflow soldering process may be inefficient, and costs may be increased.

Flanges 120

The flanges 120 extend from the main body 110 and are integrally formed therewith. In addition, the flanges 120 have a smaller area than that of the main body 110 and are thin. For example, the flanges 120 may have the same thinness as that of the main body 110 to have small vertical elasticity. The lower surfaces of the flanges 120 are provided in the form of horizontal planes, and extend outward from the main body 110.

The position and size of the flange 120 may be designed according to the thickness of the side wall 114 of the main body 110, the size and shape of a through hole formed in the flange 120, the shape of the support 200, or the position of a printed circuit board on which the flange 120 is mounted. For example, the position and size of the flange 120 may be designed to reduce a space taken by the support 200 and increase soldering strength. The flanges 120 may be symmetrically arranged, provided that vacuum pickup and reflow soldering can be efficiently performed.

The flanges 120 extend outward from the opening 112 of the main body 110. Only one of the flanges 120 may be provided to an edge of the opening 112, or the flanges 120 may be provided to all the edges of the opening 112.

Since the width of the flanges 120 is greater than the thickness of the side walls 114 of the main body 110 (than the thickness of the metal sheet constituting the main body 110), after the shield case 100 is picked up in a vacuum manner and a surface mount process is performed on the shield case 100, when a reflow soldering process is performed on the inner surfaces of the supports 200 with solder cream, the flanges 120 mounted over the molten solder cream prevents a movement of the shield case 100, thereby facilitating the reflow soldering process and improving soldering strength.

The flanges 120 may be formed of a metal sheet such as stainless steel that is resistant to reflow soldering with solder cream. In this case, since reflow soldering of the flanges 120 is difficult, a rework process is facilitated. In this case, it is unnecessary to plate the flanges 120 with, e. g., stannum that is adapted for reflow soldering with solder cream, and thus, manufacturing costs are reduced.

A printed circuit board used in mobile communication devices such as small, lightweight, and multifunctional smart phones has a number of parts to mount. In this case, the shield case 100 may be formed by pressing a metal sheet such as a stainless steel sheet that is thin, for example, has a thickness ranging from about 0.1 mm to about 0.2 mm. Although the metal sheet constituting the shield case 100 is thin, the flanges 120 and the supports 200 installed on the flanges 120 facilitate both the surface mount process using vacuum pickup and the reflow soldering process using solder cream, and further, improve soldering strength. That is, the supports 200 reinforce the flanges 120, maintain a horizontal state of the flanges 120, and reduce costs.

In addition, flexible and bendable thin printed circuit board, for example, a flexible printed circuit board (FPCB) may be coupled to the shield case 100 through a vacuum pickup process and a reflow soldering process with solder cream. Even in this case, the flanges 120, the supports 200 coupled to the flanges 120, and the reflow soldering process only for the supports 200 facilitate the reflow soldering process and a rework process, and improve soldering strength.

As described above, considering low costs, high mechanical strength, and a rework, the main body 110 and the flanges 120 may be formed of an electrically conductive material such as stainless steel, which is resistant to a reflow soldering process with solder cream.

On the contrary, when it is necessary to perform a reflow soldering process on the lower surfaces of the flanges 120 with solder cream, the lower surfaces of the flanges 120 may be plated with stanuum (Sn) that is adapted for reflow soldering with solder cream. In this case, the EMI shielding effect can be improved, but a rework after the reflow soldering process is inefficient, and costs are increased.

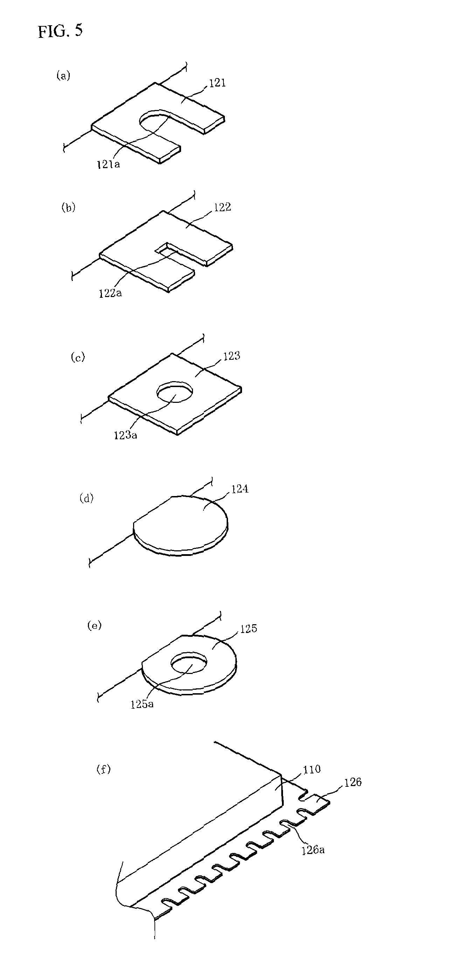

FIGS. 5A through 5F are perspective views illustrating flanges according to embodiments of the present invention.

Referring to FIGS. 5A and 5B, flanges 121 and 122 have through holes 121a and 122a, respectively, which are open toward an edge. Referring to FIG. 5C, a flange 123 has a through hole 123a defined by a closed curve.

A flange may have a tetragonal shape as illustrated in FIGS, 5A, 5B and 5C, or may have a circular shape as illustrated in FIGS. 5D and 5E.

Referring to FIG. 5F, a flange 126 may be integrally formed with the entire lower end of a side wall of the main body 110. In this case, openings 126a as illustrated in FIGS. 5A and 5B may be provided or may not be provided.

The flange 126 may be formed even at the four corners of the opening of the main body 110, and thus, the flange 126 may continuously extend. A shield case having a flange as described FIGS. 5A through 5F may be formed by performing a pressing process or a drawing (forming) process on a metal sheet or foil.

Through holes 121 a, 122a, 123a, and 125a may be coupled to the supports 200. In this case, the through holes 121a, 122a, 123a, and 125a are designed to balance the shield case 100 in the left-and-right direction or in the back-and-forth direction before and after surface mounting of the shield case 100, thereby balancing soldering strength and ensuring sufficient soldering strength.

Supports 200

The supports 200 are formed of an electrically conductive material that is thermally resistant to reflow soldering. An outermost layer of the supports 200 may be plated with stannum, a stannum alloy, or silver, which is adapted for reflow soldering with solder cream.

The bottom surface of the supports 200 is horizontal and is adapted for reflow soldering with solder cream.

The support 200 may be formed by pressing a metal sheet, but the present invention is not limited thereto, and thus, the support 200 may be formed in various shapes through various processes.

For example, the support 200 may be one of a flat metal member, a metal member in the form of a pipe, a metal member including an elastic protrusion.

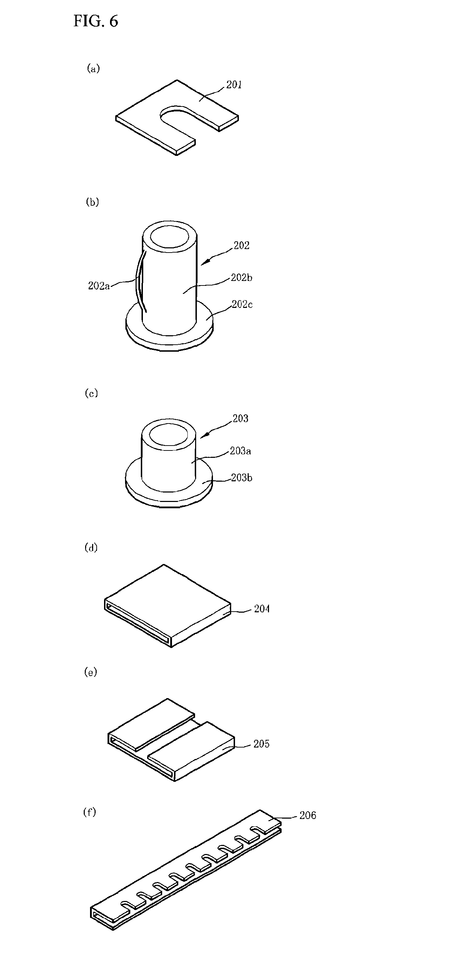

FIGS. 6A through 6F are perspective views illustrating supports according to embodiments of the present invention.

Referring to FIG. 6A, a support 201 approximately matches with the flanges 121 and 122 of FIGS. 5A and 5B, and may be attached thereto using welding or soldering.

Referring to FIG. 6B, a support 202 is elastically deformed to couple to the through holes 123a and 125a of FIGS. 5C and 5E.

In detail, the support 202 includes a base 202c, a column 202b, and an elastic deformation part 202a, which are integrally formed with one another. The base 202c is approximately the same in size and shape as a corresponding flange. The column 202b may be approximately the same in diameter as the through holes 123a and 125a to minimize a horizontal movement. The elastic deformation part 202a is configured to be elastically deformed. A size of the elastic deformation part 202a is greater than the diameters of the through holes 123a and 125a. Thus, the elastic deformation part 202a is elastically deformed to pass through the through holes 123a and 125a, and then, returns to its original position by resilient force thereof to prevent a removal or a movement thereof from the through holes 123a and 125a.

Supports 203, 204, 205, and 206 as illustrated in FIGS. 6C, 6D, 6E, and 6F may be fitted on a flange or fitted in a through hole of a flange, and may be coupled thereto using clamping.

As such, the support 200 may be reliably coupled to the flange 120 using a method such as soldering, welding, clamping, inserting, elastic deformation, or riveting.

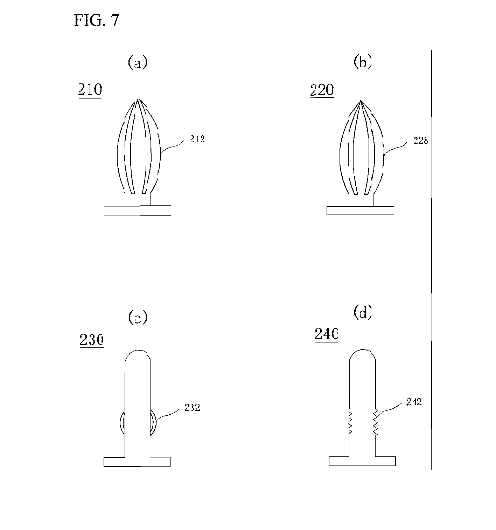

FIG. 7A, 7B, 7C and 7D are views illustrating various supports having different elastic deformation parts.

Referring to FIG. 7A, a support 210 includes elastic deformation portions 212 in oval shape. The elastic deformation portions 212 are separated from one another, and thus, gaps between the elastic deformation portions 212 allow elastic deformation. Referring to FIG. 7B, a support 220 has a hollowed oval shape. Slots 228 having a small width are formed in a surface of the hollowed oval shape, and allow elastic deformation. Referring to FIG. 7C, a support 230 includes elastic deformation portions 232 that are smaller than the elastic deformation part 202a of FIG. 6B. Referring to FIG. 7D, a support 240 includes an elastic deformation portion 241. A wrinkle area 242 is formed partially on the outer surface of the elastic deformation portion 241.

Although the supports 210, 220, 230, and 240 are exemplified, various other supports may be exemplified.

Referring to FIGS. 6C, the support 203 has a structure adapted for riveting, and includes a base 203b and a column 203a. The support 203 is fitted in the through holes 123a and 125a of the flanges 123 and 125 of FIGS. 5C and 5E, and the upper end of the column 203a is riveted to make the upper surface of the support 203 flat, so that the support 203 is coupled to the flanges 123 and 125.

The supports 204, 205, and 206 of FIGS. 6D, 6E, and 6F are adapted for clamping, which are horizontally fitted on a flange. The support 206 may be fitted on the flange 126 of FIG. 5F, which extends along the entire edge of the main body 110.

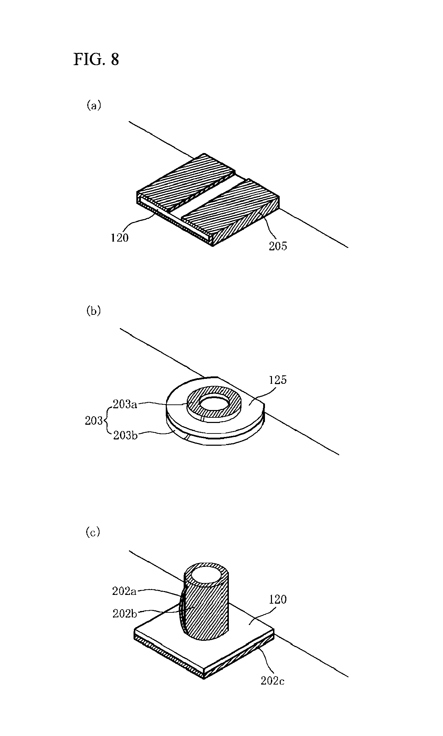

FIGS. 8A through 8C are perspective views illustrating supports coupled to flanges according to embodiments of the present invention.

Referring to FIG. 8A, the support 205 has a tetragonal box shape with an open upper surface, and is fitted on the flange 120 and is fixed thereto using clamping. For example, a vertical cross-section of the support 205 may be smaller than that of the flange 120 such that the support 205 elastically presses the flange 120, and thus, is securely fixed to the flange 120.

Referring to FIG. 8B, the column 203a of the support 203 is fitted in the through hole of the flange 125 from the lower surface of the flange 125, and the upper end of the column 203a is riveted to securely fix the support 203 to the flange 125.

Referring to FIG. 8C, the column 202b of the support 202 is fitted in the through hole of the flange 120 from the lower surface of the flange 125. At this point, an elastic deformation part 202a is elastically deformed and returns its original shape by the resilient force thereof after passing through the through hole, thereby preventing a removal or movement of the support 202 from the through hole.

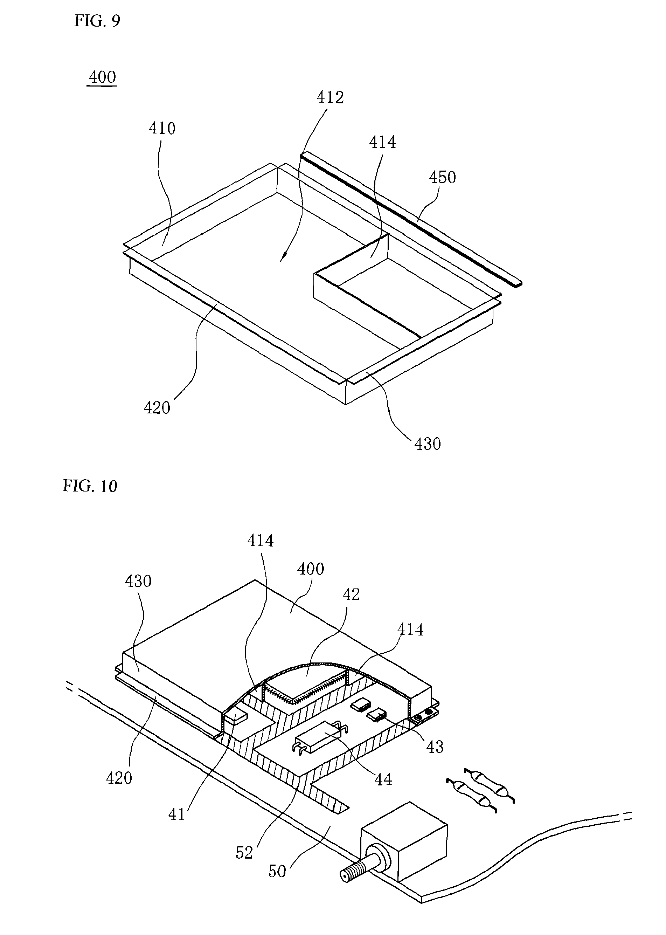

FIG. 9 is a perspective view illustrating a shield case 400 for EMI shielding according to an embodiment of the present invention. FIG. 10 is a perspective view illustrating a state in which the shield case 400 of FIG. 9 is coupled to a printed circuit board.

Referring to FIG. 9, a partition 414 for EMI shielding is disposed in an inner space 412 of a main body 410 of the shield case 400.

A support 450 adapted for reflow soldering with solder cream is disposed on a flange 420, and the shield case 400 is mounted on a ground pattern using vacuum pickup.

Forming of the partition 414 is as follows. First, electrically insulating liquid silicone rubber paste is mixed with metal powder such as copper, nickel, or silver, or with electrically conductive carbon powder, then, the liquid silicone rubber paste is stacked on the bottom surface (on the basis of FIG. 9) of the main body 410 in the inner space 412, and then, is cured with heat, moisture, or ultraviolet rays.

At this point, a dispenser is used to stack the liquid silicone rubber paste on the bottom surface of the main body 410. After that, during the curing of the liquid silicone rubber paste, the liquid silicone rubber paste is adhered to the bottom surface of the main body 410 through a self adhesion process to form the partition 414 having elasticity.

The partition 414 may have a Shore A hardness ranging from about 30 to about 60, and a resilient rate of about 85% or greater, so that the partition 414 can be efficiently adhered to the ground pattern with small force. The partition 414 may have a vertical electric resistance of about 1 ohm.

The partition 414 may have a width ranging from about 0.4 mm to about 2 mm, and a height equal to or slightly greater than the height of a side wall of the main body 410, so that the partition 414 of the shield case 400 mounted on a printed circuit board using reflow soldering can reliably contact a ground pattern disposed inside the shield case 400 and is electrically connected thereto.

After the flange 420 of the shield case 400 is soldered to a ground pattern, the partition 414 disposed on the bottom surface of the shield case 400 blocks electromagnetic waves between electronic parts or modules disposed inside the shield case 400.

The position and size of the partition 414 can be conveniently and economically determined according to a dispensing process. Thus, even when the positions of electronic parts or modules on a printed circuit board are changed, the partition 414 can be conveniently formed to correspond to the changed positions.

In addition, the partition 414 increases mechanical strength of the shield case 400 and absorbs shock.

Referring to FIG. 10, the shield case 400 is mounted on a ground pattern 52 through solder cream, and a reflow soldering process is performed. At this point, a support coupled to the lower surface of the flange 420 is soldered to the ground pattern 52 through the solder cream, and the shield case 400 is reliably, electrically and mechanically coupled to a printed circuit board 50.

At this point, the partition 414 elastically and electrically contacts the ground pattern 52 disposed inside the shield case 400, and separates an electronic module 42 from electronic parts 43 and 44 to block electromagnetic waves therebetween.

For example, a portion of the upper surface of the shield case 400 may be flat, so that the shield case 400 can be picked up in a vacuum manner for surface mounting with solder cream.

For example, a reflow soldering process for the shield case 400 may be performed only on the lower surface of a support with solder cream , but the present invention is not limited thereto.

A recess or via hole (not shown) may be formed in the ground pattern 52 contacting a support of the shield case 400. The recess or via hole has a size to receive the support protruding downward from the lower end of a side wall 430 of the main body 410, thereby preventing a movement of the shield case 400 during reflow soldering, and thus, the shield case 400 is reliably soldered to the ground pattern 52.

Furthermore, due to the recess or via hole, the flange 420 of the shield case 400 more closely contacts the ground pattern 52 after the reflow soldering.

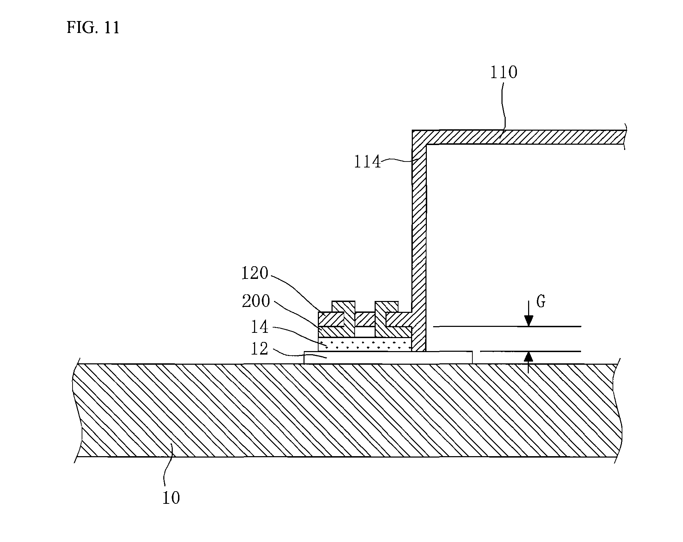

FIG. 11 is a cross-sectional view illustrating a shield case for EMI shielding according to an embodiment of the present invention.

According to the current embodiment, a predetermined gap G is formed between the lower surface of the flange 120 and the lower end of the side walls 114 of the main body 110. That is, the flange 120 protrudes from a position that is spaced a predetermined distance from the lower end of the side walls 114 of the main body 110.

The gap G is approximately equal to the sum of the thickness of the support 200 disposed on the lower surface of the flange 120 and the thickness of solder cream 14 applied on the conductive pattern 12. Thus, when a reflow soldering process is performed on the lower surface of the flange 120 with the solder cream 14, the lower end of the side walls 114 physically contacts the conductive pattern 12.

Accordingly, after the reflow soldering process, electrical contact between the lower end of the side walls 114 and the conductive pattern 12 is facilitated, thereby improving the EMI shielding effect.

For example, the dimensions and shape of the gap G may be identical along all flanges of a shield case.

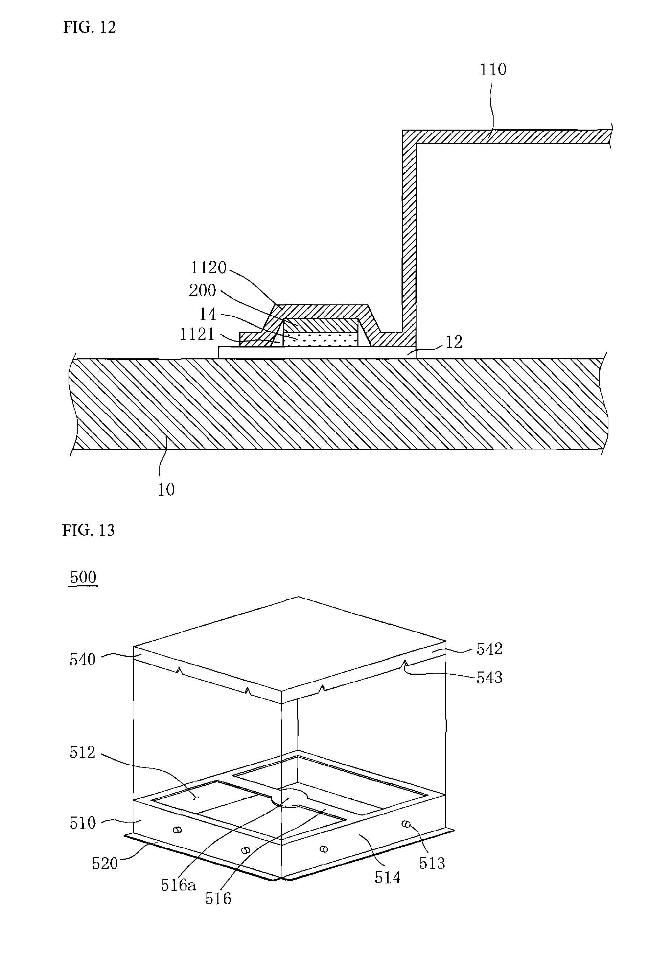

FIG. 12 is a cross-sectional view illustrating a shield case for blocking electromagnetic waves according to an embodiment of the present invention.

The middle part of the upper surface of a flange 1120 protrudes upward. That is, a recess 1121 may be formed by pressing the lower surface of the flange 1120.

According to the current embodiment, the recess 1121 has a circular shape when viewed from a bottom view, but the present invention is not limited thereto, and thus, the recess 1121 may have a polygonal shape from a bottom view. An inner surface of the recess 1121 may have a taper shape according to the characteristics of a manufacturing process.

For example, the recess 1121 may have a size to sufficiently accommodate the support 200, so that the support 200 does not protrude out of the recess 1121.

In this case, the depth of the recess 1121 is set to the sum of the thickness of the support 200 and the thickness of the solder cream 14. Accordingly, after the reflow soldering, the lower surface of the flange 120 out of the recess 1121 flushes with the solder cream 14 disposed under the support 200, and thus, the lower end of the side walls 114 of the main body 110 electrically contacts a ground pattern to improve the EMI shielding effect.

FIG. 13 is a perspective view illustrating a shield case for blocking electromagnetic waves according to an embodiment of the present invention.

A main body 510 of a shield case 500 has an upper opening 512 and a lower opening, and the upper opening 512 is covered with a metal cover 540. Flanges 520 extend outward from the edges of the lower opening of the main body 510, and are integrally formed with the main body 510. A support is adhered to the lower surface of the flange 520.

A bridge 516 crosses the upper opening 512 of the main body 510. A pickup land 516a is disposed in the middle of the bridge 516. The pickup land 516a may be used for vacuum pickup of the main body 510.

Stoppers 513 protrude from a side wall 514 of the main body 510 to adjust covering of the metal cover 540. The stoppers 513 are integrally formed with the side wall 514.

A side wall 542 is integrally formed with the four edges of the metal cover 540. The upper opening 512 of the main body 510 is fitted inside the side wall 542, and is covered.

Notches 543 are formed in the lower end of the side wall 542 of the metal cover 540. When the metal cover 540 covers the upper opening 512 of the main body 510, the stoppers 513 contact the notches 543 to horizontally balance the metal cover 540.

As configured above, the main body 510 coupled with supports without the metal cover 540 is picked up in a vacuum manner, then, the supports are soldered to a ground pattern of a printed circuit board by using reflow soldering with solder cream, then, a vision inspection process is performed through the upper opening 512, and then, the upper opening 512 is covered with the metal cover 540.

Thus, the shield case configured above is adapted for reflow soldering with vacuum pickup, and the vision inspection process is efficiently performed on electronic parts or modules inside the shield case before and after the reflow soldering. In addition, a rework process is efficiently performed.

In addition, heat generated during the reflow soldering is transferred to the inside of the shield case through the upper opening of the main body, and thus, an electronic part disposed outside the shield case and an electronic part disposed inside the shield case have a similar soldering temperature, so that, the reflow soldering process is performed on both the electronic part disposed outside the shield case and the electronic part disposed inside the shield case, thereby improving productivity.

In addition, the covering of the metal cover after the reflow soldering is facilitated, thereby improving the EMI shielding effect.

For example, the metal cover may be formed by pressing an electrically conductive metal sheet. The upper opening of the main body is covered with the metal cover with physical force after the reflow soldering. The metal cover is fitted on the upper part of the side wall of the main body.

Accordingly to the above embodiments, the shield case for EMI shielding make it possible to facilitate both a surface mount process using vacuum pickup and a reflow soldering process using solder cream, thereby improving reliability, productivity, and economic feasibility.

In addition, since a reflow soldering process using solder cream is efficiently performed on the support installed on the shield case in advance, a rework process can be facilitated, and the shield case and a printed circuit board can be slimmed.

In addition, the flanges having various dimensions and structures and the supports installed on the flanges are used to prevent a movement of the shield case during the reflow soldering and improve the soldering strength.

In addition, the vision inspection process is facilitated before and after the reflow soldering

In addition, since the number of the flanges is minimized, an area taken by the shield case is reduced, and thus, the area of a printed circuit board can be reduced.

In addition, since the main body can be removed from the support after reflow soldering, a rework process is facilitated.

Although the technical characteristics of the present invention are described according to the above embodiment, the present invention may be embodied in many different forms and should not be construed as being limited to the above embodiments.

For example, instead of using the elastically deformable support 202 as illustrated in FIG. 6B, an elastically deformable flange may be used.

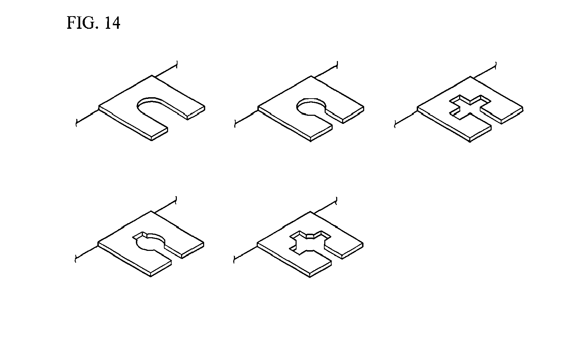

FIG. 14 is a view illustrating elastically deformable flanges having various structures according to embodiments of the present invention.

Referring to FIG. 14, flanges 120 each has an open edge. A through hole may be connected with the same width to the open edge to facilitate elastic deformation. A through hole may have a narrow slot connected to the open edge. A through hole may have a cross shape. A through hole may have slots at both sides. A cross-shaped through hole may have a through hole in the center thereof.

Since the flanges 120 can be elastically deformed by the through holes or the slots, supports can pass through the flange 120. Then, the flanges 120 return to their original shapes by resilient force and prevent removals of the supports therefrom.

According to the embodiment, since the electrically conductive support adapted for reflow soldering with solder cream is reliably installed on the flange of the shield case, surface mount and reflow soldering for the shield case are facilitated.

In addition, the support installed on the flange facilitates horizontal balancing of the flange and improves its mechanical strength, thereby improving the reliability of the reflow soldering.

In addition, after the reflow soldering, the lower surface of the flange, the lower surface of the support, the lower end of the side wall of the shield case are approximately disposed horizontally to contact a conductive pattern of a printed circuit pattern, thereby improving the EMI shielding effect.

In addition, the support installed on the flange suppresses shaking and misaligning of the shield case during surface mount and reflow soldering, thereby improving the productivity and yield.

In addition, since a reflow soldering process may be performed only on the support, costs can be saved, and a rework process is facilitated. Moreover, the main body can be efficiently removed from the support after the reflow soldering process, thereby improving the rework process.

In addition, since a reflow soldering process may be performed only on the support, the shield case is adapted for a flexible and bendable thin printed circuit board.

In addition, even when the main body of the shield case is thin, the support installed on the flange improves mechanical strength of the flange, and facilitates horizontal balancing of the flange.

In addition, the supports, the through holes, and the flanges, which have various dimensions and shapes, effectively constitute shields cases having various shapes.

In addition, since the partition disposed on the inner surface of the shield case is formed of electrically conductive rubber having elasticity and heat resistance, the partition is adapted for reflow soldering, and elastically contact a conductive pattern after the reflow soldering.

In addition, since heat generated during the reflow soldering is transferred to the inside of the shield case through the upper opening of the main body, an electronic part disposed outside the shield case and an electronic part disposed inside the shield case have a similar soldering temperature, thereby improving productivity of the reflow soldering. Furthermore, a vision inspection process is efficiently performed on electronic parts disposed inside the shield case before and after the reflow soldering, and a rework process is facilitated.

In addition, since the upper opening of the main body is covered with the metal cover after reflow soldering, the EMI shielding effect can be improved.

In addition, since the support is disposed in the via hole or the recess formed in a conductive pattern, the productivity and the soldering strength can be improved.

In addition, the upper flat portion of the main body facilitates a surface mount process with vacuum pickup.

In addition, the shield case, which is adapted for surface mount with vacuum pickup and reflow soldering with solder cream, can constitute a printed circuit board assembly.

While the present invention has been described in detail, it should be understood that various changes, substitutions and alterations can be made hereto without departing from the spirit and scope of the invention as defined by the appended claims.

## Claims

1. A shield case for electromagnetic interference shielding and protecting electronic parts, comprising:
a main body having an opening in a lower surface thereof, wherein at least one portion of an upper surface of the main body is flat for vacuum pickup, and the main body has a box shape and is electrically conductive;
a flange extending outward from an edge of the opening and integrally formed with the edge; and
a support coupled to the flange to contact at least a lower surface of the flange, wherein the support is adapted for soldering and is electrically conductive,
wherein, after the main body and the support are mounted on a printed circuit board through a surface mount process, a lower surface of the support is electrically and mechanically connected through solder cream to a conductive pattern of the printed circuit board through a reflow soldering process.

2. A shield case for electromagnetic interference shielding and protecting electronic parts, comprising:
a main body having an opening in a lower surface thereof, wherein at least one portion of an upper surface of the main body is flat for vacuum pickup, and the main body has a box shape and is electrically conductive;
a flange extending outward from an edge of the opening and integrally formed with the edge;
a through hole disposed in the flange; and
a support adapted for soldering and fitted in the through hole of the flange, the support being electrically conductive,
wherein, after the main body and the support are mounted on a printed circuit board through a surface mount process, a lower surface of the support is electrically and mechanically connected through solder cream to a conductive pattern of the printed circuit board through a reflow soldering process.

3. The shield case of claim 1 or 2, wherein the main body comprises one of a member formed by pressing a metal sheet having a constant thickness, a member formed using die casting with metal powder or metal ingot, a heat resistant polymer film including a metal layer, and a metal-plated molding member of polymer resin.

4. The shield case of claim 1 or 2, wherein a recess is disposed in the lower surface of the flange such that an upper surface of the flange protrudes.

5. The shield case of claim 4, wherein the support is disposed within the recess without protruding out of the lower surface of the flange.

6. The shield case of claim 1 or 2, wherein the lower surface of the support is formed of a material adapted for the reflow soldering process using the solder cream.

7. The shield case of claim 1 or 2, wherein the flange is coupled to the support by using one of welding, soldering, clamping, riveting, and elastic deformation.

8. The shield case of claim 2, wherein the support comprises:
a base contacting the solder cream and having a diameter greater than that of the through hole;
a column extending vertically from the base and integrally formed with the base and passing through the through hole; and
a fixing part formed by compressing an upper end of the column or integrally formed with a part having a diameter greater than that of the through hole.

9. The shield case of claim 1 or 2, further comprising a partition for electromagnetic interference shielding,
wherein the partition protrudes from a lower surface of an upper part of the shield case to form an electromagnetic interference shielding area, and is formed of electrically conductive silicone rubber.

10. The shield case of claim 1 or 2, wherein a constant gap is formed between the lower surface of the flange and a lower end of a side wall of the main body.

11. The shield case of claim 10, wherein the lower end of the side wall electrically contacts the conductive pattern after the reflow soldering process

12. The shield case of claim 1 or 2, wherein the reflow soldering process using the solder cream is performed only on the support.

13. The shield case of claim 2, wherein, after the reflow soldering process, the main body is coupled to or removed from the support by elastic deformation of the through hole with physical force or elastic deformation of the support with physical force.

14. The shield case of claim 1 or 2, wherein the main body has an upper opening used for at least one of heat transfer, vision inspection, and rework in a portion of the upper surface, and
the upper opening of the main body is covered with an electrically conductive cover that is removable.

15. The shield case of claim 14, wherein a stopper protrudes outward from a side wall of the main body,
a notch is formed at an edge of a lower end of the cover to receive the stopper,
and
the stopper is received in the notch to horizontally balance the cover.

16. A printed circuit board assembly comprising:
the shield case of claim 1 or 2; and
a printed circuit board on which the shield case is mounted
wherein, after the main body and the support are mounted on the printed circuit board through a surface mounting process, the lower surface of the support is electrically and mechanically connected through solder cream to a conductive pattern of the printed circuit board through a reflow soldering process.

17. The printed circuit board assembly of claim 16, wherein a via hole or a recess is formed in the conductive pattern connected to the support through the reflow soldering process, and receives the support.
